# EUROPEAN PATENT APPLICATION

(11) **EP 3 197 244 A1**
(43) Date of publication of application: **26.07.2017**
(21) Application number: 14901900.2
(22) Date of filing: 18.09.2014
(51) Int. Cl.: H05B 33/22, H01L 51/50, H05B 33/12

(54) **LIGHT EMITTING DEVICE**

(71) Applicant: Pioneer Corporation, Tokyo 113-0021 (JP); Tohoku Pioneer Corporation, Tendo-shi, Yamagata 994-8585 (JP)
(72) Inventor: AOKI Kenji, Yonezawa-shi Yamagata 992-1128 (JP); NARA Hiromu, Yonezawa-shi Yamagata 992-1128 (JP); KAGAMI Tomoya, Yonezawa-shi Yamagata 992-1128 (JP); KOMADA Masaki, Yonezawa-shi Yamagata 992-1128 (JP)
(74) Representative: Vossius & Partner Patentanwälte Rechtsanwälte mbB
(86) International application number: PCT/JP2014/074692
(87) International publication number: WO 2016/042638

(57) **Abstract**

A substrate (100) is a light-transmitting substrate. A light-emitting unit (140) includes a first electrode (110), an organic layer (120), and a second electrode (130). In addition, a light-emitting device (10) includes a first region (102), a second region (104), and a third region (106). The first region (102) is a region overlapping a second electrode (130). In a case where the second electrode (130) has light shielding characteristics, the first region (102) is a region through which light does not pass. The second region (104) is a region including an insulating film (150) among regions between a plurality of light-emitting units (140). The third region (106) is a region which does not include the insulating film (150) among the regions between a plurality of light-emitting units (140). A width of the second region (104) is smaller than a width of the third region (106).

## Description

### TECHNICAL FIELD

The present invention relates to a light-emitting device.

### BACKGROUND ART

In recent years, there has been progress in the development of light-emitting devices using an organic EL. Such a light-emitting device is used as an illumination device or a display device, and has a configuration in which an organic layer is interposed between a first electrode and a second electrode. Generally, a transparent material is used for the first electrode, and a metal material is used for the second electrode.

There is a technique disclosed in Patent Document 1 exemplifying the light-emitting devices using an organic EL. In the technique of Patent Document 1, the second electrode is provided only in a portion of a pixel in order to cause a display device using an organic EL to have optical transparency (see-through property). In such a structure, since a region located between a plurality of second electrodes transmits light, the display device can have optical transparency. Meanwhile, in the technique disclosed in Patent Document 1, a light-transmitting insulating film is formed between the plurality of second electrodes in order to define a pixel. In Patent Document 1, an example of a material of this insulating film includes an inorganic material such as a silicon oxide, or a resin material such as an acrylic resin.

### RELATED DOCUMENT

### PATENT DOCUMENT

[Patent Document 1] Japanese Unexamined Patent Application Publication No. 2011-23336

### SUMMARY OF THE INVENTION

As a barometer for evaluating optical transparency, there is light transmittance. The light transmittance indicates a rate of transmitted light incident on a certain object. Generally, the light transmittance of a light-transmitting material is not 100%. For this reason, in a case where an insulating film is present in a region through which light passes as disclosed in Patent Document 1, a portion of light is absorbed when the light passes through the insulating film. In this case, the light transmittance of the light-emitting device is deteriorated.

The exemplified problem to be solved by the present invention is to increase a light transmittance of a light-emitting device.

According to the invention of claim 1, there is provided a light-emitting device including: a translucent substrate; a plurality of light-emitting units formed over the substrate, each light-emitting unit including a translucent first electrode, a second electrode, at least a portion of which overlaps the first electrode, and an organic layer located between the first electrode and the second electrode; and an insulating film that covers an edge of the first electrode. In the light-emitting device, the plurality of light-emitting units are separated from each other, and at least a portion of the insulating film is not covered with the second electrode. The light-emitting device, when viewed from a direction perpendicular to the substrate, includes: a first region which is a region overlapping the second electrode; a second region which is a region including the insulating film out of a region between the plurality of light-emitting units; and a third region which is a region not including the insulating film out of the region between the plurality of light-emitting units. A width of the second region is smaller than a width of the third region.

### BRIEF DESCRIPTION OF THE DRAWINGS

The above and other objects, features and advantages will be made clearer from certain preferred embodiments described below, and the following accompanying drawings.

FIG. 1 is a cross-sectional view illustrating a configuration of a light-emitting device according to an embodiment.
FIG. 2 is an enlarged view of a light-emitting unit of the light-emitting device.
FIG. 3 is a plan view of the light-emitting device.
FIG. 4 is a cross-sectional view illustrating a configuration of a light-emitting device according to Example 1.
FIG. 5 is a cross-sectional view illustrating a configuration of a light-emitting device according to Example 2.
FIG. 6 is a cross-sectional view illustrating a configuration of a light-emitting device according to Example 3.
FIG. 7 is a cross-sectional view illustrating a configuration of a light-emitting device according to Example 4.
FIGS. 8(a) to 8(c) are enlarged views of a region surrounded by a dotted line α of FIG. 7.
FIG. 9 is a cross-sectional view illustrating a configuration of a light-emitting device according to Example 5.
FIG. 10 is a plan view of the light-emitting device shown in FIG. 9.
FIG. 11 is a plan view illustrating a modification example of FIG. 10.

### DESCRIPTION OF EMBODIMENTS

Hereinafter, an embodiment of the present invention will be described with reference to the accompanying drawings. In all the drawings, like elements are referenced by like reference numerals and the descriptions thereof will not be repeated.

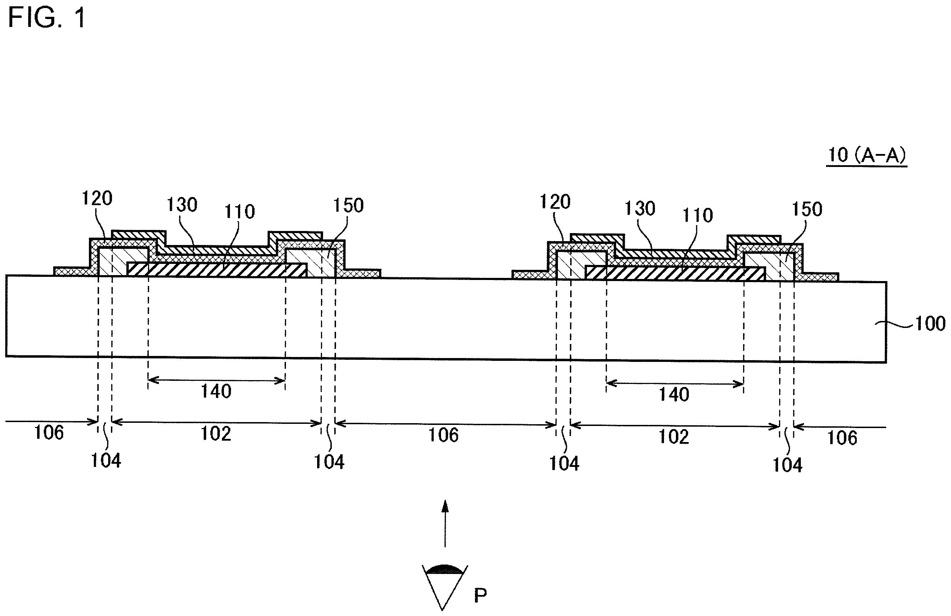

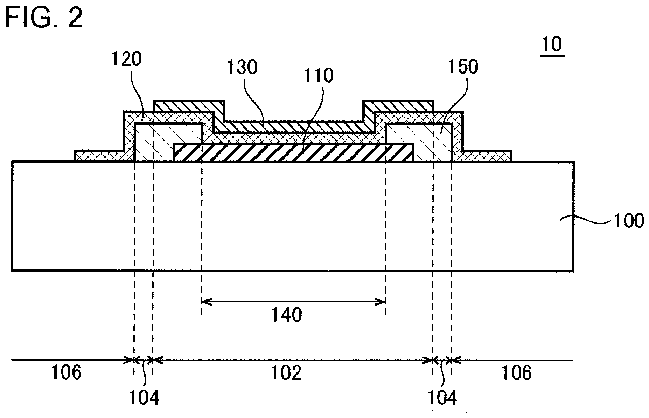

FIG. 1 is a cross-sectional view illustrating a configuration of a light-emitting device 10 according to an embodiment. An observer P observes a light emission surface of the light-emitting device 10 from a direction perpendicular to a substrate 100 of FIG. 1. FIG. 2 is an enlarged view of a light-emitting unit 140 of the light-emitting device 10. The light-emitting device 10 according to the embodiment is an illumination device or a display device. FIGS. 1 and 2 show a case where the light-emitting device 10 is an illumination device. The light-emitting device 10 includes the substrate 100, a plurality of light-emitting units 140, and an insulating film 150. A light-transmitting material is used for the substrate 100. The plurality of light-emitting units 140 are separated from each other, each unit including a first electrode 110, an organic layer 120, and a second electrode 130. The first electrode 110 is a light-transmitting electrode, and the second electrode 130 is a light-shielding electrode, at least a portion thereof overlapping the first electrode 110. However, the second electrode 130 may be a light-transmitting electrode. The organic layer 120 is located between the first electrode 110 and the second electrode 130. The insulating film 150 covers the edge of the first electrode 110. In addition, at least a portion of the insulating film 150 is not covered with the second electrode 130.

When viewed from a direction perpendicular to the substrate 100, the light-emitting device 10 includes a first region 102, a second region 104, and a third region 106. The first region 102 is a region overlapping the second electrode 130. That is, the first region 102 is a region which is covered with the second electrode 130 when viewed from the direction perpendicular to the substrate 100. In a case where the second electrode 130 has light shielding properties, the first region 102 is a region through which light does not pass. The second region 104 is a region including the insulating film 150 out of the region between the plurality of light-emitting units 140. The third region 106 is a region which does not include the insulating film 150 among the region between the plurality of light-emitting units 140. The width of the second region 104 is smaller than the width of the third region 106. Hereinafter, the detailed description thereof will be given.

The substrate 100 is a substrate such as, for example, a glass substrate or a resin substrate which has translucency. The substrate 100 may have flexibility. In a case where the substrate has flexibility, the thickness of the substrate 100 is, for example, equal to or greater than 10 µm and equal to or less than 1,000 µm. The substrate 100 is polygonal such as, for example, rectangular or circular. In a case where the substrate 100 is a resin substrate, the substrate 100 is formed using, for example, polyethylene naphthalate (PEN), polyether sulphone (PES), polyethylene terephthalate (PET), or polyimide. In addition, in a case where the substrate 100 is a resin substrate, it is preferable that an inorganic barrier film of SiNx, SiON or the like is formed on at least one surface (preferably, both surfaces) of the substrate 100 in order to suppress permeation of moisture through the substrate 100.

The light-emitting unit 140 is formed on one surface of the substrate 100. The light-emitting unit 140 has a configuration in which the first electrode 110, the organic layer 120, and the second electrode 130 are laminated in this order. In a case where the light-emitting device 10 is an illumination device, the plurality of light-emitting units 140 extend linearly. On the other hand, in a case where the light-emitting device 10 is a display device, the plurality of light-emitting units 140 may be disposed so as to form a matrix, or may be configured so as to form a segment or display a predetermined shape (so as to display, for example, an icon). The plurality of light-emitting units 140 are formed for each pixel.

The first electrode 110 is a transparent electrode having optical transparency. A material of the transparent electrode is a material containing a metal, for example, a metal oxide such as an indium tin oxide (ITO), an indium zinc oxide (IZO), an indium tungsten zinc oxide (IWZO), a zinc oxide (ZnO) or the like. The thickness of the first electrode 110 is, for example, equal to or greater than 10 nm and equal to or less than 500 nm. The first electrode 110 is formed using, for example, sputtering or vapor deposition. Meanwhile, the first electrode 110 may be a conductive organic material such as a carbon nanotube or PEDOT/PSS. In FIG. 1, a plurality of first linear electrodes 110 are formed on the substrate 100 in parallel to each other. For this reason, the first electrode 110 is not located in the second region 104 and the third region 106.

The organic layer 120 includes a light-emitting layer. The organic layer 120 has a configuration in which, for example, a hole injection layer, a light-emitting layer, and an electron injection layer are laminated in this order. A hole transport layer may be formed between the hole injection layer and the light-emitting layer. In addition, an electron transport layer may be formed between the light-emitting layer and the electron injection layer. The organic layer 120 may be formed by vapor deposition. In addition, at least one layer of the organic layer 120, for example, a layer which is in contact with the first electrode 110 may be formed by coating, for example, by ink jet, printing, or spraying. Meanwhile, in this case, the remaining layers of the organic layer 120 are formed by vapor deposition. In addition, all the layers of the organic layer 120 may be formed by coating.

The second electrode 130 includes a metal layer composed of a metal selected from a first group consisting of, for example, Al, Au, Ag, Pt, Mg, Sn, Zn, and In, or an alloy of metals selected from this first group. In this case, the second electrode 130 has light shielding properties. The thickness of the second electrode 130 is, for example, equal to or greater than 10 nm and equal to or less than 500 nm. However, the second electrode 130 may be formed using a material exemplified as the material of the first electrode 110. The second electrode 130 is formed by, for example, sputtering or vapor deposition. In the example shown in FIG. 1, the light-emitting device 10 includes a plurality of second linear electrodes 130. The second electrode 130 is provided for each of the first electrodes 110, and is larger in width than the first electrode 110. For this reason, the entirety of the first electrode 110 is overlapped and covered with the second electrode 130 in a width direction when viewed from the direction perpendicular to the substrate 100. In addition, the first electrode 110 may be larger in width than the second electrode 130, and the entirety of the second electrode 130 may be covered with the first electrode 110 in a width direction when viewed from the direction perpendicular to the substrate 100.

The edge of the first electrode 110 is covered with the insulating film 150. The insulating film 150 is formed of a photosensitive resin material such as, for example, polyimide, and surrounds a portion of the first electrode 110 which serves as the light-emitting unit 140. The edge of the second electrode 130 in a width direction is located over the insulating film 150. In other words, when viewed from the direction perpendicular to the substrate 100, a portion of the insulating film 150 protrudes from the second electrode 130. In addition, in the example shown in FIGS. 1 and 2, the organic layer 120 is formed on the top and a lateral side of the insulating film 150. However, the organic layer 120 is separated between the light-emitting units 140 next to each other.

As described above, the light-emitting device 10 includes the first region 102, the second region 104, and the third region 106. The first region 102 is a region overlapping the second electrode 130. The second region 104 is a region including the insulating film 150 out of the region between the plurality of light-emitting units 140. In the example shown in FIGS. 1 and 2, the organic layer 120 is also formed in the second region 104. The third region 106 is a region which does not include the insulating film 150 out of the region between the plurality of light-emitting units 140. In the example shown in FIGS. 1 and 2, the organic layer 120 is not formed in at least a portion of the third region 106. The width of the second region 104 is smaller than the width of the third region 106. In addition, the width of the third region 106 may be larger or smaller than the width of the first region 102. In a case where the width of the first region 102 is set to 1, the width of the second region 104 is, for example, equal to or greater than 0 (or exceeds 0) and equal to or less than 0.2, and the width of the third region 106 is, for example, equal to or greater than 0.3 and equal to or less than 2. In addition, the width of the first region 102 is, for example, equal to or greater than 50 µm and equal to or less than 500 µm, the width of the second region 104 is, for example, equal to or greater than 0 µm (or exceeds 0 µm) and equal to or less than 100 µm, and the width of the third region 106 is, for example, equal to or greater than 15 µm and equal to or less than 1, 000 µm.

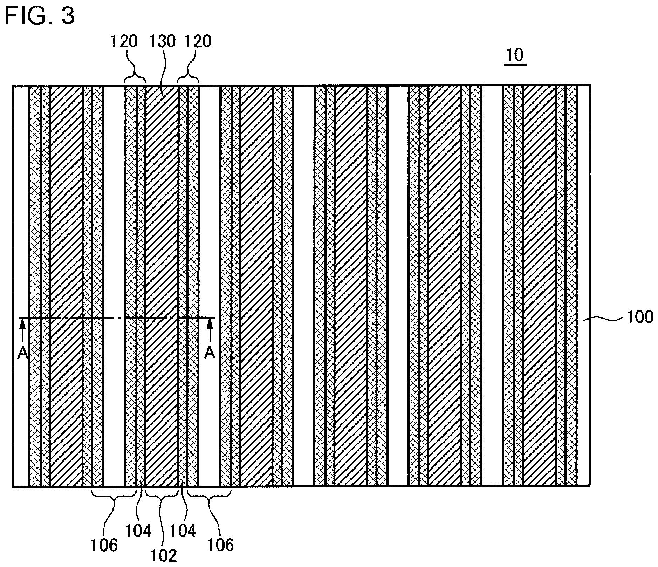

FIG. 3 is a plan view of the light-emitting device 10. Meanwhile, FIG. 1 corresponds to a cross-section A-A of FIG. 3. In the example shown in FIG. 3, the first region 102, the second region 104, and the third region 106 all extend linearly and in the same direction. As shown in FIG. 3 and FIG. 1, the second region 104, the first region 102, the second region 104, and the third region 106 are repeatedly aligned in this order.

Next, a method of manufacturing the light-emitting device 10 will be described. First, the first electrode 110 is formed on the substrate 100 by, for example, sputtering. Next, the first electrode 110 is formed in a predetermined pattern by, for example, photolithography. Next, the insulating film 150 is formed on the edge of the first electrode 110. For example, in a case where the insulating film 150 is formed of a photosensitive resin, the insulating film 150 is formed in a predetermined pattern by undergoing exposure and development steps. Next, the organic layer 120 and the second electrode 130 are formed in this order. In a case where the organic layer 120 includes a layer which is formed by vapor deposition, this layer is formed in a predetermined pattern using, for example, a mask or the like. The second electrode 130 is also formed in a predetermined pattern using, for example, a mask or the like. Thereafter, the light-emitting unit 140 is sealed using a sealing member (not shown).

In the present embodiment, the first region 102 out of the first region 102, the second region 104, and the third region 106 is lowest in light transmittance. In addition, the second region 104 is set lower in light transmittance than the third region 106 owing to the existence of the insulating film 150. In the present embodiment, the width of the second region 104 is smaller than the width of the third region 106. For this reason, in the light-emitting device 10, the area occupancy ratio of the second region 104 is lower than the area occupancy ratio of the third region 106. Therefore, the light transmittance of the light-emitting device 10 becomes higher.

In addition, the insulating film 150 is formed of a light-transmitting material, but the light transmittance of the light-transmitting material generally differs depending on the wavelength of light. Therefore, when light penetrates the insulating film 150 in a case where the width of the insulating film 150 is large, the spectral distribution of the light changes. In this case, when an object is viewed through the light-emitting device 10, the color of the object appears different from the actual color. That is, the color of the object is changed through the light-emitting device 10. For example, in a case where the absorption of a blue wavelength of 400 nm to 600 nm is 50% and is larger than the absorption of other wavelengths, blue color is lowered and the object appears yellowish when viewed through the light-emitting device 10. On the other hand, in the present embodiment, the width of the second region 104 is smaller than the width of the third region 106, and thus it is possible to suppress the aforementioned change in color.

### [Examples]

### (Example 1)

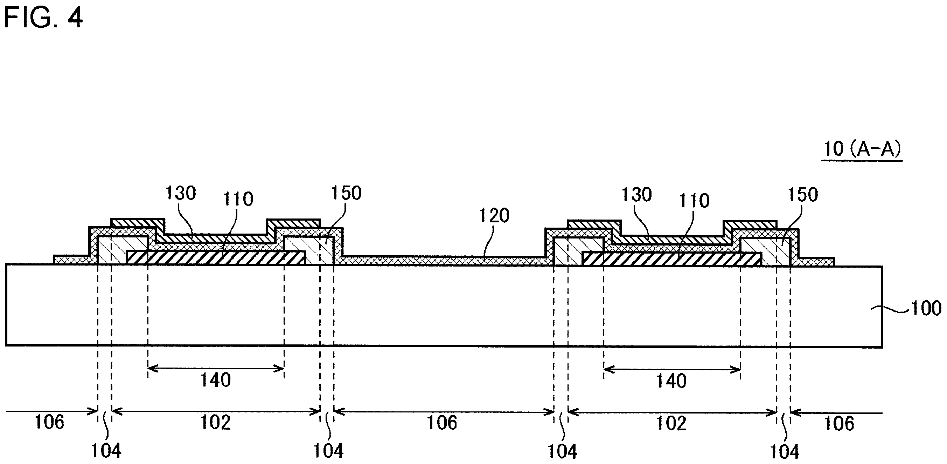

FIG. 4 is a cross-sectional view illustrating a configuration of a light-emitting device 10 according to Example 1, and corresponds to FIG. 1 in the embodiment. The light-emitting device 10 according to the present example has the same configuration as that of the light-emitting device 10 according to embodiment, except for the layout of the organic layer 120.

In the present embodiment, the organic layer 120 is formed on the entire surface of the third region 106. In other words, the organic layer 120 is continuously formed throughout the first region 102, the second region 104, and the third region 106. The organic layer 120 is continuously formed so as to connect the plurality of light-emitting units 140 to each other.

In the present example, as is the case with the embodiment, the light transmittance of the light-emitting device 10 increases. In addition, since the organic layer 120 is continuously formed, costs for forming the organic layer 120 are reduced.

### (Example 2)

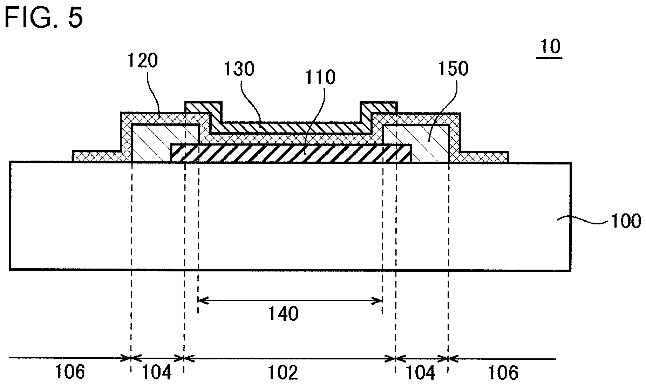

FIG. 5 is a cross-sectional view illustrating a configuration of a light-emitting device 10 according to Example 2, and corresponds to FIG. 2 in the embodiment. The light-emitting device 10 according to the present example has the same configuration as that of the light-emitting device 10 according to Example 1, except for the width of the second electrode 130.

In the present example, the width of the second electrode 130 is smaller than the width of the first electrode 110. For this reason, the end of the first electrode 110 protrudes from the second electrode 130 in a width direction when viewed from the direction perpendicular to the substrate 100. In other words, a portion of the second region 104 overlaps the first electrode 110.

In the present example, as is the case with the embodiment, the light transmittance of the light-emitting device 10 increases.

### (Example 3)

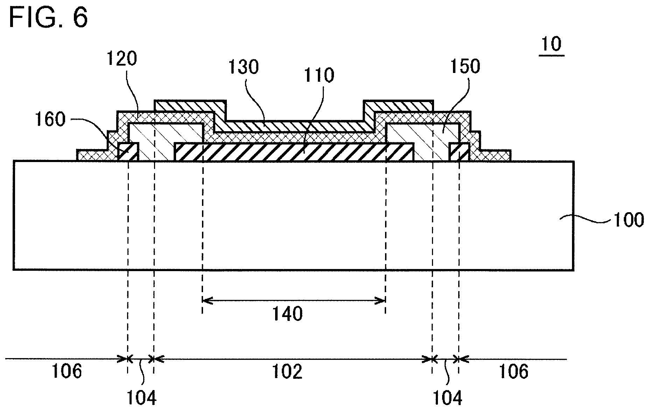

FIG. 6 is a cross-sectional view illustrating a configuration of the light-emitting device 10 according to Example 3, and corresponds to FIG. 2 in the embodiment. The light-emitting device 10 according to the present example has the same configuration as that of the light-emitting device 10 according to Example 1, except that an anti-detachment unit 160 is included therein.

The anti-detachment unit 160 is provided on a surface of the substrate 100 having the light-emitting unit 140 formed thereon. The anti-detachment unit 160 is insulated from the first electrode 110, and is formed of a material having higher adhesiveness to the insulating film 150 than the substrate 100. The insulating film 150 is formed from the edge of the first electrode 110 and over the anti-detachment unit 160. In the example shown in FIG. 6, the anti-detachment unit 160 is formed of the same material as that of the first electrode 110, and is insulated from the first electrode 110 by being physically separated from the first electrode 110. In this case, the anti-detachment unit 160 is formed in the same step as that in which the first electrode 110 is formed. The insulating film 150 is also formed on a region of the substrate 100 which is located between the anti-detachment unit 160 and the first electrode 110. The edge of the insulating film 150 is located on the anti-detachment unit 160.

In the present example, as is the case with the embodiment, the light transmittance of the light-emitting device 10 increases. In addition, the edge of the insulating film 150 is located on the anti-detachment unit 160. The adhesiveness between the anti-detachment unit 160 and the insulating film 150 is higher than the adhesiveness between the substrate 100 and the insulating film 150. Therefore, it is possible to prevent the insulating film 150 from being detached.

### (Example 4)

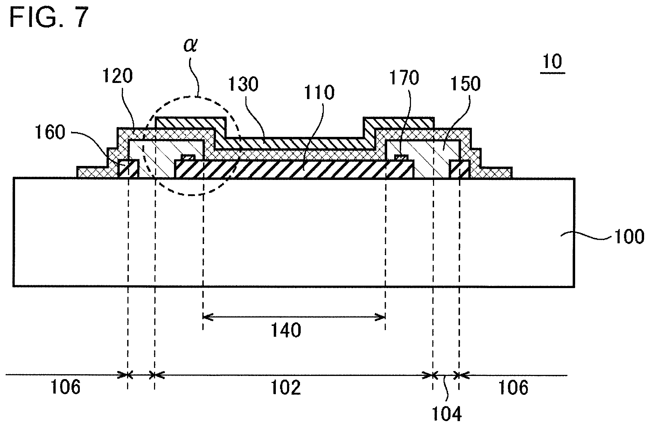

FIG. 7 is a cross-sectional view illustrating a configuration of a light-emitting device 10 according to Example 4, and corresponds to FIG. 2 in the embodiment. The light-emitting device 10 according to the present example has the same configuration as that of the light-emitting device 10 according to Example 3, except that a conductive portion 170 is included therein.

The conductive portion 170 is, for example, an auxiliary electrode of the first electrode 110, and is in contact with the first electrode 110. The conductive portion 170 is formed of a material having a resistance value lower than that of the first electrode 110, and is formed of, for example, at least one metal layer. The conductive portion 170 has, for example, a configuration in which a first metal layer of Mo, a Mo alloy or the like, a second metal layer of Al, an Al alloy or the like, and a third metal layer of Mo, a Mo alloy or the like are laminated in this order. The second metal layer out of these three metal layers is thickest. The conductive portion 170 is covered with the insulating film 150. For this reason, the conductive portion 170 is not connected directly to any of the organic layer 120 and the second electrode 130.

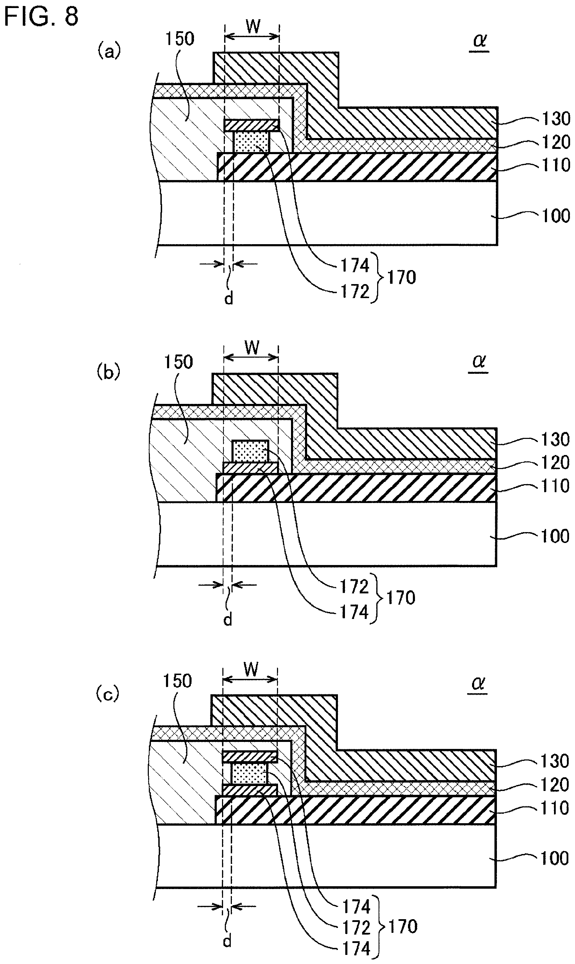

FIG. 8(a) is a first example of an enlarged view of a region surrounded by a dotted line α of FIG. 7. In the example shown in FIG. 8(a), the conductive portion 170 has a configuration in which a second layer 174 is laminated on a first layer 172. The first layer 172 is formed of a metal such as, for example, Al or an Al alloy, and the second layer 174 is formed of a conductive material which is higher in hardness and lower in etching rate than the first layer 172, for example, Mo or a Mo alloy. In addition, the first layer 172 is formed of a material lower in resistance than that of the second layer 174. In a case where the first layer 172 is formed of an AlNd alloy, the second layer 174 is formed of a MoNb alloy. The thickness of the first layer 172 is, for example, equal to or greater than 50 nm and equal to or less than 1,000 nm. The thickness is preferably equal to or less than 600 nm. The second layer 174 is thinner than the first layer 172. The thickness of the second layer 174 is, for example, equal to or less than 100 nm, preferably equal to or less than 60 nm, and more preferably equal to or less than 30 nm.

In addition, the reflectance of visible light of the second layer 174 is lower than the reflectance of visible light of the first layer 172. For example, the reflectance of light having a wavelength of 530 nm in the second layer 174 is approximately 60%, and that in the first layer 172 is approximately 90%.

The width of the first layer 172 is smaller than the width of the second layer 174. For this reason, the end of the first layer 172 is located closer to the center of the conductive portion 170 compared to the end of the second layer 174 in the width direction of the conductive portion 170. A distance "d" between the end of the first layer 172 and the end of the second layer 174 is preferably equal to or greater than 150 nm, and is more preferably equal to or greater than 300 nm.

In addition, at least a portion of the conductive portion 170 overlaps the second electrode 130. It is preferable that the width "w" of a portion of the conductive portion 170 which overlaps the second electrode 130 is, for example, equal to or greater than 150 nm. In the example shown in FIG. 8(a), the entirety of the conductive portion 170 is overlapped by the second electrode 130.

A timing at which the conductive portion 170 is formed is posterior to the formation of the first electrode 110 and prior to the formation of the insulating film 150. The conductive portion 170 is formed, for example, as follows. First, the first layer 172 and the second layer 174 are formed in this order by film formation such as, for example, by sputtering. Next, a resist pattern (not shown) is formed on the second layer 174, and the second layer 174 and the first layer 172 are etched (for example, wet-etched) using the resist pattern as a mask. At this time, the etching is performed isotropically. In addition, in the conditions of this etching, the etching rate of the first layer 172 is higher than the etching rate of the second layer 174. Therefore, the first layer 172 is etched faster than the second layer 174. As a result, the lateral side of the first layer 172 comes closer toward the center of the conductive portion 170 than the lateral side of the second layer 174. That is, the end of the first layer 172 is located closer to the center of the conductive portion 170 compared to end of the second layer 174. Meanwhile, the length of the distance "d" is controlled by adjusting the etching conditions (for example, the etching time).

In the present example, as is the case with the embodiment, the light transmittance of the light-emitting device 10 increases. In addition, since the conductive portion 170 is formed on the first electrode 110, it is possible to lower the apparent resistance value of the first electrode 110. In addition, the color of an object when the object is viewed through the light-emitting device 10 is prevented from appearing as a different color from that in reality.

In addition, since the conductive portion 170 is covered with the insulating film 150, when light is reflected from the end face of the conductive portion 170, the amount of light passing through the insulating film 150 is increased. Since the light transmittance of the insulating film 150 differs depending on the wavelength of light, an increase in the amount of the light passing through the insulating film 150 causes the color of the object to highly possibly appear changed when the object is viewed through the light-emitting device 10. On the other hand, in the present embodiment, the reflectance of visible light in the second layer 174 is lower than the reflectance of visible light in the first layer 172. The end of the first layer 172 is located closer to the center of the conductive portion 170 compared to the end of the second layer 174. Therefore, at least a portion of light incident on the end of the first layer 172 is shielded by the second layer 174. Thereby, it is possible to reduce the amount of the light passing through the insulating film 150.

Meanwhile, as shown in FIG. 8(b), the conductive portion 170 may have a configuration in which the first layer 172 is laminated on the second layer 174. In this case, at least a portion of light reflected from the end of the first layer 172 is shielded by the second layer 174 before the light is incident on the substrate 100. Thereby, it is possible to reduce the amount of the light passing through the insulating film 150.

In addition, as shown in FIG. 8(c), the conductive portion 170 may have a configuration in which the second layer 174, the first layer 172, and the second layer 174 are laminated in this order. In the example of FIG. 8(c), the thicknesses of the two second layers 174 may be different from each other, and may be the same as each other.

### (Example 5)

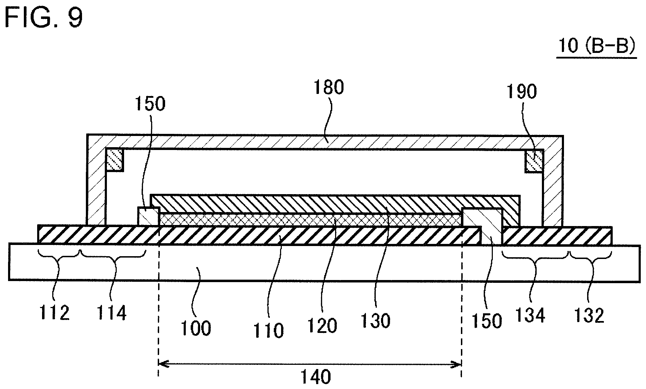

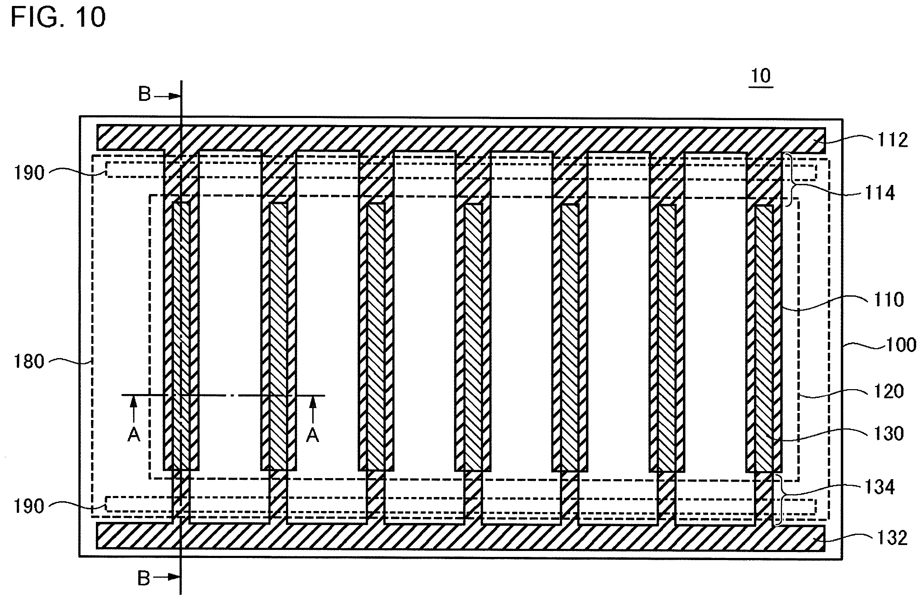

FIG. 9 is a cross-sectional view illustrating a configuration of a light-emitting device 10 according to Example 5. FIG. 10 is a plan view of the light-emitting device 10 shown in FIG. 9. However, in FIG. 10, some of members are omitted. FIG. 9 corresponds to a cross-section B-B of FIG. 10. The light-emitting device 10 according to the present example has the same configuration as that of the light-emitting device 10 according to any one of the embodiment and Examples 1 to 4, except that a sealing member 180 and a drying agent 190 are included therein.

In the example shown in FIGS. 9 and 10, the planar shape of the substrate 100 is polygonal such as, for example, rectangular or circular. The sealing member 180 has translucency, and is formed using, for example, glass or a resin. The sealing member 180 has the same polygonal or circular shape as that of the substrate 100, and has a shape in which a concave portion is provided in its center. The edge of the sealing member 180 is fixed to the substrate 100 by an adhesive material. Thereby, a space surrounded by the sealing member 180 and the substrate 100 is sealed. A plurality of light-emitting units 140 are all located in the sealed space.

In addition, the light-emitting device 10 includes a first terminal 112, a first extraction interconnect 114, a second terminal 132, and a second extraction interconnect 134. The first terminal 112, the first extraction interconnect 114, the second terminal 132, and the second extraction interconnect 134 are all formed on a surface of the substrate 100 which is flush with the light-emitting unit 140. The first terminal 112 and the second terminal 132 are located outside the sealing member 180. The first extraction interconnect 114 connects the first terminal 112 to the first electrode 110, and the second extraction interconnect 134 connects the second terminal 132 to the second electrode 130. In other words, both the first extraction interconnect 114 and the second extraction interconnect 134 extend from the inside of the sealing member 180 to the outside thereof.

The first terminal 112, the second terminal 132, the first extraction interconnect 114, and the second extraction interconnect 134 include, for example, a layer formed of the same material as that of the first electrode 110. In addition, at least a portion of at least one of the first terminal 112, the second terminal 132, the first extraction interconnect 114, and the second extraction interconnect 134 may include a metal film lower in resistance than the first electrode 110 (for example, the same film as that of the conductive portion 170) on the layer. The metal film is not necessarily required to be formed on all of the first terminal 112, the second terminal 132, the first extraction interconnect 114, and the second extraction interconnect 134. A layer formed of the same material as that of the first electrode 110 among the first terminal 112, the first extraction interconnect 114, the second terminal 132, and the second extraction interconnect 134 is formed in the same step as that in which the first electrode 110 is formed. Therefore, the first electrode 110 is formed integrally with at least a portion of a layer of the first terminal 112. In addition, in a case where these components include a metal film, the metal film is formed, for example, in the same step as that in which the conductive portion 170 is formed. In this case, the light transmittance of the first terminal 112, the first extraction interconnect 114, the second terminal 132, and the second extraction interconnect 134 becomes lower than the light transmittance of the substrate 100.

In the example shown in FIGS. 9 and 10, one each of the first extraction interconnect 114 and the second extraction interconnect 134 are formed for every light-emitting unit 140. A plurality of first extraction interconnects 114 are all connected to the same first terminal 112, and a plurality of second extraction interconnects 134 are all connected to the same second terminal 132. The positive electrode terminal of a control circuit is connected to the first terminal 112 through a conductive member such as a bonding wire or a lead terminal, and the negative electrode terminal of the control circuit is connected to the second terminal 132 through a conductive member such as a bonding wire or a lead terminal.

The drying agent 190 is disposed in a region of a space sealed with the sealing member 180 which does not overlap any of the light-emitting units 140 when viewed from a direction perpendicular to the substrate 100, for example, a region which overlaps at least one of the first extraction interconnect 114 and the second extraction interconnect 134.

Specifically, the drying agent 190 contains a drying member of, for example, CaO, BaO or the like. The light transmittance of the drying agent 190 is lower than the light transmittance of the substrate 100. The drying agent 190 is fixed to a surface facing the substrate 100 of the sealing member 180. In the example shown in FIGS. 9 and 10, the drying agent 190 is disposed in each of a region overlapping the first extraction interconnect 114 and a region overlapping the second extraction interconnect 134. In other words, the drying agent 190 is disposed so as to be along two sides of the rectangular substrate 100 which face each other, but is not disposed at positions along the remaining two sides, that is, the drying agent 190 is not disposed along the remaining two sides and on the light-emitting unit 140.

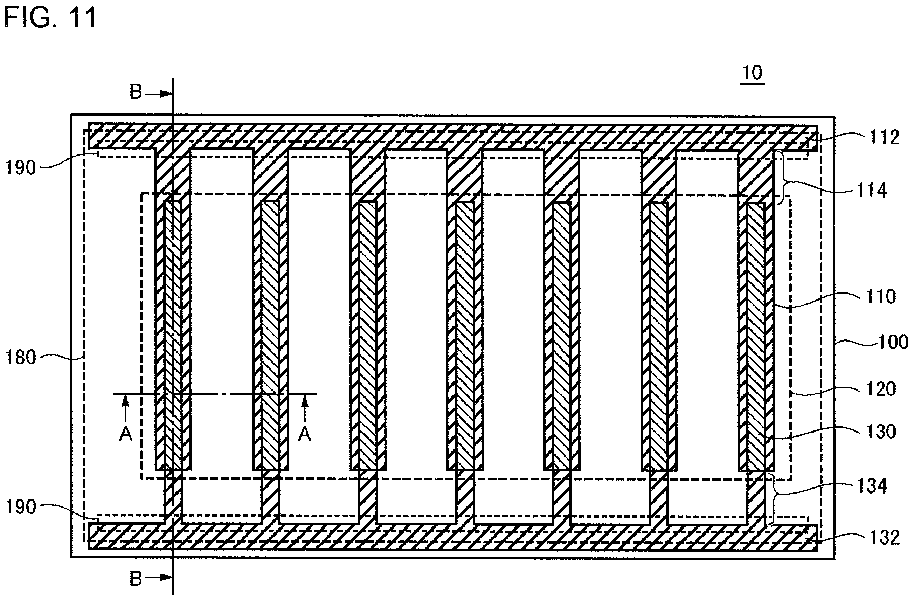

FIG. 11 is a plan view illustrating a modification example of FIG. 10. In the example shown in FIG. 11, some of the first terminal 112 and the second terminal 132 are located inside the sealing member 180. At least a portion of the drying agent 190 overlaps at least one of the first terminal 112 and the second terminal 132.

In the present example, as is the case with the embodiment, the light transmittance of the light-emitting device 10 increases. In addition, when viewed from the direction perpendicular to the substrate 100, the drying agent 190 does not overlap the light-emitting unit 140, and is located near the edge of the substrate 100. Therefore, the drying agent 190 is hardly visually recognizable by a user compared to a case where the drying agent 190 is provided at a position overlapping the light-emitting unit 140. Particularly, in the present embodiment, the drying agent 190 overlaps the first extraction interconnect 114 and the second extraction interconnect 134. The first extraction interconnect 114 and the second extraction interconnect 134 are low in light transmittance. For this reason, the light transmittance of the light-emitting device 10 is further improved than in a case where the drying agent 190 does not overlap the first extraction interconnect 114 and the second extraction interconnect 134. Particularly, in a case where the first terminal 112 and second terminal 132 and the drying agent 190 overlap each other, the light transmittance of the light-emitting device 10 is further improved than in a case where these terminals and the drying agent do not overlap each other.

In addition, the luminance in the light-emitting unit 140 differs depending on the temperature of the organic layer 120. In a case where the drying agent 190 is provided at a position overlapped with the organic layer 120, at least a portion of heat radiated from the light-emitting unit 140 is absorbed by the drying agent 190. Therefore, the temperature of a region of the organic layer 120 which is overlapped with the drying agent 190 becomes lower than in another region of the organic layer 120. In this case, an in-plane variation occurs in the luminance in the light-emitting unit 140.

On the other hand, in the present example, the drying agent 190 does not overlap the light-emitting unit 140. Therefore, it is possible to suppress the occurrence of an in-plane variation in the luminance in the light-emitting unit 140.

In addition, the luminance in a region located near the first extraction interconnect 114 and the luminance in a region located near the second extraction interconnect 134 in the light-emitting unit 140 become higher compared to the luminance in the central portion of the light-emitting unit 140, due to the resistances of the first electrode 110 and the second electrode 130. On the other hand, in the present example, the drying agent 190 is provided at a position overlapping the first extraction interconnect 114 and a position overlapping the second extraction interconnect 134. Thereby, both the temperature of the region located near the first extraction interconnect 114 and the temperature of the region located near the second extraction interconnect 134 in the organic layer 120 become lower than the temperature of a region located at the central portion of the light-emitting unit 140 in the organic layer 120. Thereby, the variation of luminance in the light-emitting unit 140 caused by the resistances of the first electrode 110 and the second electrode 130 is absorbed. Therefore, the in-plane variation of the luminance in the light-emitting unit 140 is reduced.

As described above, although the embodiments and examples of the present invention have been set forth with reference to the accompanying drawings, they are merely illustrative of the present invention, and various configurations other than those stated above can be adopted.

## Claims

1. A light-emitting device comprising:
a translucent substrate;
a plurality of light-emitting units formed over the substrate, each light-emitting unit including a translucent first electrode, a second electrode, at least a portion of which overlaps the first electrode, and an organic layer located between the first electrode and the second electrode; and
an insulating film that covers an edge of the first electrode,
wherein the plurality of light-emitting units are separated from each other,
at least a portion of the insulating film is not covered with the second electrode,
wherein the light-emitting device, when viewed from a direction perpendicular to the substrate, comprises:
a first region which is a region overlapping the second electrode;
a second region which is a region including the insulating film out of a region between the plurality of light-emitting units; and
a third region which is a region not including the insulating film out of the region between the plurality of light-emitting units, and
wherein a width of the second region is smaller than a width of the third region.

2. The light-emitting device according to claim 1, wherein the second region, the first region, the second region, and the third region are repeatedly aligned in this order.

3. The light-emitting device according to claim 1 or 2, wherein the first region, the second region, and the third region extend in the same direction.

4. The light-emitting device according to any one of claims 1 to 3, wherein at least a portion of the organic layer is continuously formed throughout the first region, the second region, and the third region.

5. The light-emitting device according to any one of claims 1 to 4, further comprising a conductive portion formed over the first electrode and covered with the insulating film, the conductive portion being composed of a material having a resistance value lower than that of the first electrode.

6. The light-emitting device according to any one of claims 1 to 5, further comprising:
an anti-detachment unit provided on the substrate and insulated from the first electrode, the anti-detachment unit being composed of a material having higher adhesiveness to the insulating film than the substrate,
wherein the insulating film is formed from the edge of the first electrode over the anti-detachment unit, and an edge of the insulating film is located over the anti-detachment unit.
